Europäisches Patentamt

European Patent Office

Office européen des brevets

(19)

(11) Veröffentlichungsnummer: **0 341 520 B1**

(12) # EUROPÄISCHE PATENTSCHRIFT

(45) Veröffentlichungstag der Patentschrift: **28.10.92**

(21) Anmeldenummer: **89107820.6**

(22) Anmeldetag: **28.04.89**

(51) Int. Cl.5: **H01L 39/24**, C23C 14/08, C23C 14/28, C04B 35/00

(54) **Verfahren zur Herstellung einer Schicht aus einem metalloxidischen Supraleitermaterial mittels Laser-Verdampfens.**

(30) Priorität: **11.05.88 DE 3816192**

(43) Veröffentlichungstag der Anmeldung:
**15.11.89 Patentblatt 89/46**

(45) Bekanntmachung des Hinweises auf die Patenterteilung:
**28.10.92 Patentblatt 92/44**

(84) Benannte Vertragsstaaten:
**AT CH DE FR GB IT LI NL SE**

(56) Entgegenhaltungen:

**APPLIED PHYSICS LETTERS, Band 52, Nr. 12, 21. März 1988, Seiten 1008-1010, American Institute of Physics, New York, NY, US; S. MIURA et al.: "Structure and superconducting properties of Y1Ba2Cu3O7-delta films prepared by transversely excited atmospheric pressure CO2 pulsed laser evaporation"**

(73) Patentinhaber: **SIEMENS AKTIENGESELL-SCHAFT**
**Wittelsbacherplatz 2**
**W-8000 München 2(DE)**

(72) Erfinder: **Roas, Bernhard, Dipl.-Phys.**
**Brahmsstrasse 6**
**W-8520 Erlangen(DE)**
Erfinder: **Endres, Gerhard, Dr.**
**Leygeberstrasse 4**
**W-8550 Forchheim(DE)**
Erfinder: **Schultz, Ludwig, Dr.**
**Amselweg 22**
**W-8526 Bubenreuth(DE)**

DIALOG INSPEC, no. A89037184, High-Temperature Superconductors Symposium, 30. November - 4. Dezember 1987; K. TACHI-KAWA et al.: "High-T/sub c/ superconducting films of Y-Ba-Cu oxide prepared by a CO/sub 2/ laser beam evaporation", & MATER. RES. SOC. SYMP. PROC., Band 99, 1988, Seiten 723-726

APPLIED PHYSICS LETTERS, Band 52, Nr. 4, 25. Januar 1988, Seiten 320-322, American Institute of Physics, New York, NY, US; L. LYNDS et al.: "Superconducting thin films of Y-Ba-Cu-O produced by neodymium:yttrium aluminum garnet laser ablation"

APPLIED PHYSICS LETTERS, Band 51, Nr. 22, 30. November 1987, Seiten 1845-1847, American Institute of Physics, New York, NY, US; J. NARAYAN et al.: "Formation of thin superconducting films by the laser processing method"

APPLIED PHYSICS LETTERS, Band 52, Nr. 3, 18. Januar 1988, Seiten 239-241, American Institute of Physics, New York, NY, US; O. AUCIELO et al.: "Surface compositional and topographical changes resulting from excimer laser impacting on YBa2Cu3O7 single phase superconductors"

SOLID STATE TECHNOLOGY, Band 30, Nr. 12, Dezember 1987, Port Washington, NY, US; T. VENKATESAN: "Laser deposited high Tc superconducting thin films"

**Beschreibung**

Die Erfindung bezieht sich auf ein Verfahren zur Herstellung einer Schicht aus einem oxidkeramischen supraleitenden Material mit hoher Sprungtemperatur und hoher Stromtragfähigkeit auf Basis eines metallische Komponenten und Sauerstoff enthaltenden Stoffsystems, bei welchem Verfahren ein Targetmaterial des Stoffsystems mittels eines gepulsten Lasers, dessen Wellenlänge im ultraviolett-Spektralbereich liegt, verdampft und auf einem vorbestimmten Substrat abgeschieden wird und bei welchem mittels einer Wärmebehandlung und einer Sauerstoffbehandlung die gewünschte supraleitende Metalloxidphase mit einer zumindest teilweise geordneten Kristallstruktur ausgebildet wird. Ein entsprechendes Verfahren geht z.B. aus der Veröffentlichung "Applied Physics Letters", Vol. 51, No. 11, 14.9.1987, Seiten 861 bis 863 hervor.

Supraleitende Metalloxidverbindungen mit hohen Sprungtemperaturen $T_c$ von insbesondere über 90 K sind allgemein bekannt. Diese Metalloxidverbindungen können beispielsweise auf einem Stoffsystem des Typs Me1-Me2-Cu-O basieren, wobei die Komponenten Me1 ein Seltenes Erdmetall wie z.B. Y und Me2 ein Erdalkalimetall wie z.B. Ba zumindest enthalten. Filme bzw. dünne Schichten aus diesen Metalloxidverbindungen werden vielfach mit speziellen Bedampfungs- oder Sputterprozessen hergestellt. Hierbei wird im allgemeinen auf einem geeigneten Substrat zunächst ein polykristallines oder amorphes Vorprodukt mit den Komponenten des gewählten Stoffsystems abgeschieden, wobei im allgemeinen der Sauerstoffgehalt und damit die gewünschte Phase noch nicht exakt eingestellt sind. Dieses Vorprodukt wird anschließend mittels einer Wärme- und Sauerstoffbehandlung in das Material mit der gewünschten supraleitenden Phase überführt.

Die so zu erhaltenden supraleitenden Metalloxidphasen, deren Kristallstrukturen ähnlich der eines Perowskites sein können, haben im Falle von $YBa_2Cu_3O_{7-x}$ mit $0 < x < 0,5$ eine orthorhombische Struktur (vgl. z.B. "Europhysics Letters", Vol. 3, No. 12, 15.6.1987, Seiten 1301 bis 1307). Ihre Sprungtemperatur $T_c$ liegt dabei bei etwa 90 K. Da die diese supraleitenden Phasen aufweisenden Materialien den Oxidkeramiken zuzurechnen sind, werden die entsprechenden Hoch-$T_c$-Supraleiter vielfach auch als oxidkeramische Supraleiter bezeichnet.

Aus der eingangs genannten Veröffentlichung "Appl.Phys.Lett." ist bekannt, einkristalline Filme des Systems $YBa_2Cu_3O_{7-x}$ auf einem einkristallinen $SrTiO_3$-Substrat mittels Epitaxie herzustellen. Hierzu wird zunächst ein Targetmaterial des genannten Stoffsystems mittels eines Lasers verdampft und auf dem Substrat mit der geordneten Kristalstruktur abgeschieden. Der verwendete Laser ist ein KrF-Excimer-Laser, der eine Wellenlänge seiner Strahlung im Ultraviolett(UV)-Spektralbereich hat und eine Energiedichte am Targetmaterial von etwa 2 J/cm² bei einer Pulsfrequenz von 3 bis 6 Hz ermöglicht. Das Substrat ist dabei auf 450°C erhitzt (vgl. hierzu auch "Appl. Phys.Lett.", Vol. 51, No. 8, 24.8.87, Seiten 619 bis 621). Die so erhaltene Schicht ist jedoch hinsichtlich der gewünschten supraleitenden Hoch-$T_c$-Phase noch fehlstrukturiert. Mittels einer sich daran anschließenden Wärmebehandlung bei hoher Temperatur von etwa 900°C in einer Sauerstoffatmosphäre und anschließender langsamer Abkühlung erhält man dann epitaktisch aufgewachsene einkristalline oder zumindest stark texturierte Filmschichten mit der gewünschten supraleitenden Hoch-$T_c$-Phase.

Derartige Filmschichten zeichnen sich durch hohe kritische Stromdichten aus, die bei 77 K über $10^5$ A/cm² betragen können. Die erwähnte Epitaxie wird dabei als notwendige Voraussetzung zur Erreichung solch hoher kritischer Stromdichten angesehen. Der Aufwand zur Herstellung entsprechender Schichten ist bei dem bekannten Verfahren jedoch erheblich. Außerdem ist die bei dem Hochtemperaturprozeß ablaufende Epitaxie schwierig zu kontrollieren. Insbesondere ist eine Interdiffusion zwischen dem Filmmaterial und dem Substrat in vielen Fällen nicht zu vermeiden.

Aufgabe der vorliegenden Erfindung ist es, das Verfahren der eingangs genannten Art dahingehend auszugestalten, daß mit ihm auf verhältnismäßig einfache Weise entsprechende Schichten mit kritischen Stromdichten von mindestens $10^4$ A/cm² in der Nähe der Sprungtemperatur $T_c$ reproduzierbar herzustellen sind, ohne daß der erwähnte Hochtemperaturprozeß erforderlich wäre.

Diese Aufgabe wird erfindungsgemäß dadurch gelöst, daß die Wärmebehandlung und die Sauerstoffbehandlung gleichzeitig während des Verdampfungsschrittes durchgeführt werden, wobei

a) eine Energiedichte der Laserstrahlung am Targetmaterial von mehr als 3 J/cm²,

b) eine Pulsenergie des Lasers von mindestens 1,5 J/Puls,

c) eine Aufheizung des Substrates auf eine Temperatur zwischen 600°C und 800°C sowie

d) eine Atmosphäre mit einem Sauerstoff-Partialdruck zwischen 0,02 mbar und 1 mbar vorgesehen werden.

Die mit den erfindungsgemäßen Maßnahmen erreichten Vorteile sind insbesondere darin zu sehen, daß quasi "in-situ" eine Kristallisation der gewünschten supraleitenden Phase zu erreichen ist und deshalb eine nachträgliche Ausbildung dieser Phase durch einen gesonderten Glühschritt bei hohen Temperaturen nicht mehr erforderlich wird.

Das Verfahren ist deshalb insbesondere zur Ausbildung von Hybridstrukturen aus halbleitendem und supraleitendem Material einsetzbar. Daneben läßt sich mit ihm auch eine supraleitende Elektronik mit an sich bekannten Elementen wie z.B. Josephson-Tunnelelementen oder SQUIDs herstellen.

Für die erfindungsgemäße In-situ-Kristallisation sind höhere Substrattemperaturen und aktivierter Sauerstoff am Substrat notwendig. Zur Aktivierung des Sauerstoffs ist eine möglichst hohe Pulsenergie des Lasers von mindestens 1,5 J/Puls erforderlich. Der molekulare Sauerstoff der vorgesehenen Atmosphäre wird dann bei den angegebenen Druckverhältnissen durch Wechselwirkung mit der UV-Laserstrahlung direkt an dem geheizten Substrat mit jedem Puls aktiviert. Die so erzeugte Menge an Sauerstoffradikalen und die hohe Substrattemperatur reichen aus, um bei jedem Puls eine etwa 1 nm dicke Schicht epitaktisch aufwachsen zu lassen. Die bei üblichen Pulsfrequenzen so erreichbaren hohen Aufwachsraten gewährleisten eine geringe Bedampfungsdauer und eine geringe Verunreinigung der Schichten. Zur Erhaltung der Stöchiometrie beim Verdampfungsprozeß wird vorteilhaft eine Energiedichte der Laserstrahlung von über 3 J/cm$^2$ vorgesehen.

Vorteilhafte Ausgestaltungen des erfindungsgemäßen Verfahrens gehen aus den abhängigen Ansprüchen hervor.

Mit dem erfindungsgemäßen Verfahren ist mindestens eine dünne Schicht oder mindestens ein Film aus einem bekannten supraleitenden Hoch-$T_c$-Material auf einem Substrat abzuscheiden. Als Ausführungsbeispiel sei ein Material aus dem Stoffsystem Me1-Me2-Cu-O ausgewählt. Das erfindungsgemäße Verfahren ist jedoch nicht nur auf dieses Stoffsystem beschränkt; d.h., es ist ebensogut auch für andere oxidkeramische, metallische Komponenten und Sauerstoff enthaltende Hoch-$T_c$-Supraleitermaterialien geeignet, die dem genannten System nicht zuzurechnen sind. Entsprechende Materialien sind z.B. aus "Superconductivity News", Vol. 1, No. 9, 18.3.1988, Seiten 1 bis 5 und 13 bis 16 bekannt. Die mit dem erfindungsgemäßen Verfahren herzustellen den Schichten aus den genannten oxidkeramischen supraleitenden Materialien sollen dabei eine hohe Stromtragfähigkeit in der Größenordnung von mindestens 10$^4$ A/cm$^2$ in der Nähe der Sprungtemperatur $T_c$ des Materials gewährleisten. Vorteilhaft sind insbesondere solche Materialien, deren Sprungtemperatur deutlich über der Verdampfungstemperatur des flüssigen Stickstoffs von etwa 77 K liegen.

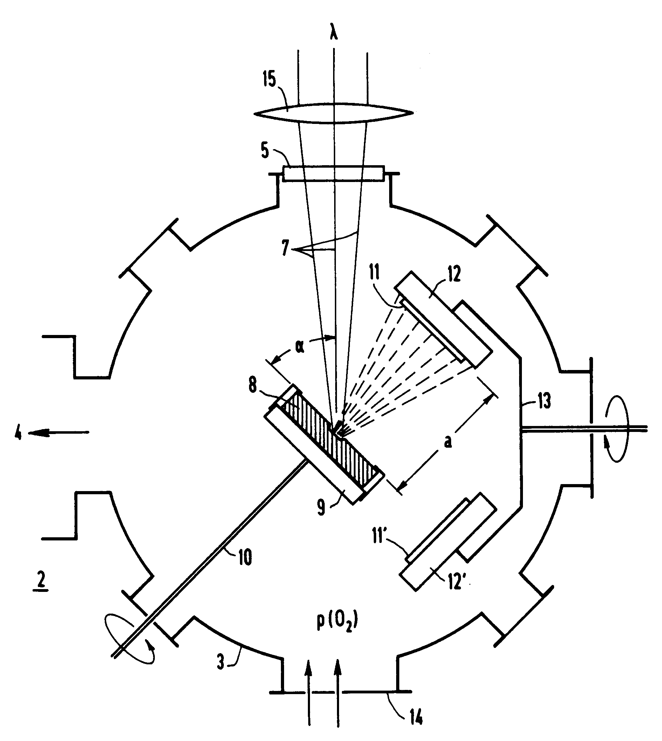

Die Erfindung wird nachfolgend unter Bezugnahme auf die Zeichnung noch weiter erläutert. In der Figur der Zeichnung ist schematisch eine Vorrichtung zur Durchführung des erfindungsgemäßen Verfahrens veranschaulicht.

Dabei sei als Ausführungsbeispiel ein Material der Zusammensetzung Me1-Me2-Cu-O gewählt, wobei Me1 und Me2 insbesondere aus der Gruppe der Seltenen Erdmetalle wie z.B. Y bzw. aus der Gruppe der Erdalkalimetalle wie z.B. Ba gewählt sind. Neben Y und Ba für Me1 bzw. Me2 geeignete Materialien sind allgemein bekannt. Gegebenenfalls sind Me1 und Me2 auch Legierungen oder Verbindungen oder sonstige Zusammensetzungen dieser Metalle mit Substitutionsmaterialien; d.h., mindestens eines der genannten Elemente kann in bekannter Weise partiell durch ein anderes Element substituiert sein. Auch das Cu oder das O können partiell substituiert sein.

Die für das Substrat zu wählenden Materialien sind vorteilhaft solche, die eine Struktur mit Abmessungen ihrer Einheitszellen haben, die zumindest in etwa das Ein- oder Mehrfache der entsprechenden Abmessungen der Achsen der auf ihnen aufgewachsenen Strukturen des supraleitenden Hoch-$T_c$-Materials ausmachen. Aus diesem Grunde ist im Falle von YBa$_2$Cu$_3$O$_{7-x}$ ein einkristallines SrTiO$_3$- oder (Ba,Sr)TiO$_3$-Substrat besonders vorteilhaft. Daneben sind ebenso auch andere Werkstoffe wie z.B. MgO, Al$_2$O$_3$, Y-stabilisiertes ZrO$_2$ oder Ta$_2$O$_5$ geeignet. Dabei ist das erfindungsgemäße Verfahren nicht unbedingt auf einkristalline Substrate beschränkt. So können gegebenenfalls auch polykristalline Substrate wie z.B. polykristallines, auf einen Träger aufgedampftes SrTiO$_3$ vorgesehen werden. Das Substrat kann z.B. verhältnismäßig kleinflächig und beispielsweise für eine Verwendung auf mikrotechnischem Gebiet vorgesehen sein. Daneben kann eine Vorrichtung zur Durchführung des erfindungsgemäßen Verfahrens auch so gestaltet sein, daß mit ihr ein langgestrecktes Substrat zu beschichten ist, das z.B. bandförmig gestaltet ist und zur Herstellung von entsprechenden Leitern dient.

Als ein entsprechendes konkretes Ausführungsbeispiel sei nachfolgend die erfindungsgemäße Abscheidung einer Schicht aus einem supraleitenden Material der bekannten Zusammensetzung YBa$_2$Cu$_3$O$_{7-x}$ mit orthorhombischer Struktur auf einem einkristallinen SrTiO$_3$-Substrat zugrundegelegt. Hierzu dient eine entsprechende Vorrichtung, die in der Figur schematisch als Querschnitt veranschaulicht und allgemein mit 2 bezeichnet ist. Diese Abscheidevorrichtung enthält eine Vakuumkammer 3, die an einem Pumpstutzen 4 mittels einer entsprechenden Pumpe auf einen Enddruck zu evakuieren ist, der z.B. unter 10$^{-6}$ mbar liegt. Durch ein Quarzfenster 5 der Vakuumkammer 3 tritt ein Laserstrahl 7 in die Kammer ein und trifft dort unter einem Winkel $\alpha$ von beispielsweise etwa 45° auf ein Target 8. Das Target ist im Zentrum der Kammer an einem Halter 9 befestigt, der mit Hilfe eines Motors über ein Gestänge 10 gedreht werden kann. Aus dem Target 8 wird das verdampfte Material senkrecht zur Targetoberfläche emittiert. Es kondensiert auf einem Substrat 11, das sich dem Target gegenüber befindet. Hierzu ist das Substrat 11, beispielsweise ein Plättchen aus dem genannten Material, an einem Substratträger 12 befestigt. Dieser Substratträger 12 ist auf eine Temperatur von mindestens 800°C aufheizbar. Er wird von einem Gestänge 13 gehalten, das eine Variation des Abstandes a zwischen dem Target 8 und dem Substrat 11 ermöglicht. So läßt sich z.B. ein Abstand a zwischen 20 mm und 45 mm einstellen. Das Gestänge kann ferner so ausgestaltet sein, daß innerhalb der Vakuumkammer 3 ein weiteres Substrat 11′ auf einem Substratträger 12′ gegen das Substrat 11 auswechselbar ist. Während des Bedampfens kann in der Kammer ein beliebiger Sauerstoff-Partialdruck $p(O_2)$ über einen Gaseinlaß 14 eingestellt werden.

Um während des Aufdampfungsschrittes in-situ die gewünschte supraleitende Hoch-$T_c$-Phase des Materials zu erzeugen, wird vorteilhaft ein gepulster Laser mit einer Wellenlänge $\lambda$ seiner Strahlung vorgesehen, die im UV-Spektralbereich liegt. Der hier interessierende Wellenlängenbereich erstreckt sich dabei von etwa 110 nm bis 400 nm. Außerdem muß der Laser eine Energiedichte am Material des Targets 8 hervorrufen können, die über 3 $J/cm^2$ liegt. Darüber hinaus sollte die Pulsenergie des Lasers mindestens 1,5 J/Puls betragen. Die genannten Forderungen können insbesondere mit einem an sich bekannten XeCl-Excimer-Laser erfüllt werden, dessen Strahlung eine Wellenlänge $\lambda = $ 308 nm hat (vgl. z.B. "Proc. of SPIE", Vol. 735, 1987, Beitrag von J.-H.Cirkel et al: "Pulse power for Lasers"). Seine Wiederholungsfrequenz kann beispielsweise bei 5 Hz liegen. Durch eine Fokussierungsoptik, von der in der Figur lediglich eine Quarzlinse 15 veranschaulicht ist, kann am Target 8 eine Energiedichte erzeugt werden, die maximal etwa 7,5 $J/cm^2$ beträgt. Im allgemeinen sind Energiedichten von 4 bis 5 $J/cm^2$ ausreichend. Während des Aufdampfungsprozesses muß das Substrat 11 auf einer Temperatur zwischen 600°C und 800°C gehalten werden, wobei in der Kammer eine Sauerstoffatmosphäre zwischen 0,02 mbar und und 1 mbar eingestellt ist. Ein Sauerstoff-Partialdruck $p(O_2)$ zwischen 0,05 mbar und 0,5 mbar hat sich als besonders günstig erwiesen.

Vielfach ist es noch vorteilhaft, wenn man den so gewonnenen Aufbau einer zusätzlichen Sauerstoff-Behandlung unterzieht, um hiermit eine Sauerstoff-Feineinstellung (-beladung) in dem Kristallgefüge der supraleitenden Schicht vorzunehmen. Dabei kann der Sauerstoff als Gas oder als Ionenstrom zugeführt werden. Diese Behandlung kann man vorteilhaft bei verhältnismäßig niedrigen Temperaturen, insbesondere unterhalb von 600°C durchführen. Gegebenenfalls können sogar Temperaturen nahe Raumtemperatur vorgesehen werden.

**Patentansprüche**

1. Verfahren zur Herstellung einer Schicht aus einem oxidkeramischen supraleitenden Material mit hoher Sprungtemperatur und hoher Stromtragfähigkeit auf Basis eines metallische Komponenten und Sauerstoff enthaltenden Stoffsystems, bei welchem Verfahren ein Targetmaterial des Stoffsystems mittels eines gepulsten Lasers, dessen Wellenlänge im Ultraviolett-Bereich liegt, auf einem vorbestimmten Substrat abgeschieden wird und bei welchem mittels einer Wärmebehandlung und einer Sauerstoffbehandlung die gewünschte supraleitende Metalloxidphase mit einer zumindest teilweise geordneten Kristallstruktur ausgebildet wird, **dadurch gekennzeichnet,** daß die Wärmebehandlung und die Sauerstoffbehandlung gleichzeitig während des Verdampfungsschrittes durchgeführt werden, wobei

    a) eine Energiedichte der Laserstrahlung (7) am Targetmaterial (8) von über 3 $J/cm^2$,
    b) eine Pulsenergie des Lasers von mindestens 1,5 J/Puls,
    c) eine Aufheizung des Substrates (11) auf eine Temperatur zwischen 600°C und 800°C sowie
    d) eine Atmosphäre mit einem Sauerstoff-Partialdruck ($p(O_2)$) zwischen 0,02 mbar und 1 mbar vorgesehen werden.

2. Verfahren nach Anspruch 1, **dadurch gekennzeichnet,** daß ein XeCl-Excimer-Laser vorgesehen wird.

3. Verfahren nach Anspruch 1 oder 2, **dadurch gekennzeichnet,** daß eine Energiedichte der Laserstrahlung (7) am Targetmaterial (8) zwischen 4 und 5 $J/cm^2$ vorgesehen wird.

4. Verfahren nach einem der Ansprüche 1 bis 3, **dadurch gekennzeichnet,** daß eine Sauerstoffatmosphäre mit einem Sauerstoff-Partialdruck ($p(O_2)$) zwischen 0,05 mbar und 0,5 mbar vorgesehen wird.

5. Verfahren nach einem der Ansprüche 1 bis 4, **dadurch gekennzeichnet,** daß ein Substrat (11) aus einem Material aus der Gruppe $SrTiO_3$, $Al_2O_3$, $ZrO_2$, MgO gewählt wird.

6. Verfahren nach Anspruch 5, **dadurch gekennzeichnet,** daß ein Substrat (11) mit einer der Kristallstruktur der herzustellenden supraleitenden Metalloxidphase angepaßten Textur vorgesehen wird.

7. Verfahren nach einem der Ansprüche 1 bis 6, **dadurch gekennzeichnet,** daß nach dem Verdampfungsschritt eine zusätzliche Sauerstoffbehandlung bei einer Temperatur unterhalb von 600°C vorgenommen wird.

8. Verfahren nach einem der Ansprüche 1 bis 7, **dadurch gekennzeichnet,** daß ein oxidkeramisches supraleitendes Material auf Basis des Stoffsystems Me1-Me2-Cu-O vorgesehen wird, wobei die metallischen Komponenten Me1 und Me2 ein Seltenes Erdmetall oder Yttrium bzw. ein Erdalkalimetall zumindest enthalten.

## Claims

1. Process for the production of a layer of an oxide-ceramic superconductor material having a high transition temperature and high current capacity, based on a material system containing metallic constituents and oxygen, in which process a target material of the material system is deposited on a predetermined substrate by means of a pulsed laser with a wavelength in the ultraviolet range, and in which the desired superconducting metal oxide phase with an at least partially ordered crystal structure is formed by means of a heat treatment and an oxygen treatment, characterised in that the heat treatment and the oxygen treatment are carried out simultaneously during the vaporizing step, there being provided:
   - a power density of the laser radiation (7) on the target material (8) of more than 3 $J/cm^2$;
   - a pulse power of the laser of at least 1, 5 J/pulse;
   - heating of the substrate (11) to a temperature of between 600°C and 800°C; and
   - an atmosphere with a partial pressure of oxygen ($p(O_2)$) of between 0.02 mbar and 1 mbar.

2. Process according to claim 1, characterised in that an XeCl-excimer laser is provided.

3. Process according to claim 1 or 2, characterised in that a power density of the laser radiation (7) of between 4 and 5 $J/cm^2$ is provided on the target material (8).

4. Process according to one of claims 1 to 3, characterised in that an oxygen atmosphere with a partial pressure of oxygen ($p(O_2)$) of between 0.05 mbar and 0.5 mbar is provided.

5. Process according to one of claims 1 to 4, characterised in that a substrate (11) is selected of a material from the group $SrTiO_3$, $Al_2O_3$, $ZrO_2$, MgO.

6. Process according to claim 5, characterised in that there is provided a substrate (11) with a texture adapted to the crystal structure of the superconductor metal oxide phase to be produced.

7. Process according to one of claims 1 to 6, characterised in that after the vaporising step an additional oxygen treatment is carried out at a temperature below 600°C.

8. Process according to one of claims 1 to 7, characterised in that an oxide-ceramic superconductor material based on the material system Me1-Me2-Cu-O is provided, wherein the metallic components Me1 and Me2 contain at least a rare earth metal or yttrium or an earth alkali metal.

## Revendications

1. Procédé de fabrication d'une couche d'oxyde céramique supraconducteur, ayant une température élevée de changement brusque de la conductivité et une grande capacité à supporter le courant électrique, à base d'un système comprenant des constituants métalliques et de l'oxygène, procédé qui consiste à déposer une substance cible du système sur un substrat déterminé à l'avance au moyen d'un laser déclenché, dont la longueur d'onde se trouve dans le domaine ultraviolet, et à constituer la phase d'oxyde métallique supraconductrice, qui est souhaitée et qui possède une structure cristalline au moins partiellement ordonnée, au moyen d'un traitement thermique et d'un traitement à l'oxygène, caractérisé en ce qu'il consiste à effectuer le traitement thermique et le traitement à l'oxygène en même temps que le stade d'évaporation, en prévoyant
   a) une densité d'énergie du rayonnement laser (7) sur la substance cible (8) supérieure à 3 $J/cm^2$;
   b) une énergie d'impulsion du laser d'au moins 1,5 J/impulsion,
   c) de porter le substrat (11) à une température comprise entre 600°C et 800°C, ainsi que
   d) une atmosphère ayant une pression partielle d'oxygène ($p(O_2)$) comprise entre 0,02 mbar et 1 mbar.

2. Procédé suivant la revendication 1, caractérisé en ce qu'il consiste à prévoir un laser excimère à XeCl.

3. Procédé suivant la revendication 1 ou 2, caractérisé en ce qu'il consiste à prévoir une densité d'énergie du rayonnement laser (7) sur la substance cible (8) comprise entre 4 et 5 $J/cm^2$.

4. Procédé suivant l'une des revendications 1 à 3, caractérisé en ce qu'il consiste à prévoir une atmosphère d'oxygène ayant une pression partielle d'oxygène ($p(O_2)$) comprise entre 0,05 mbar et 0,5 mbar.

5. Procédé suivant l'une des revendications 1 à 4, caractérisé en ce qu'il consiste à choisir un substrat (11) en un matériau pris dans le groupe constitué de $SrTiO_3$, $Al_2O_3$, $ZrO_2$ et MgO.

6. Procédé suivant la revendication 5, caractérisé en ce qu'il consiste à prévoir un substrat (11) ayant une texture adaptée à la structure cristalline de la phase d'oxyde métallique supraconductrice à obtenir.

7. Procédé suivant l'une des revendications 1 à 6, caractérisé en ce qu'il consiste à effectuer, après le stade d'évaporation, un traitement supplémentaire à l'oxygène à une température inférieure à 600°C.

8. Procédé suivant l'une des revendications 1 à 7, caractérisé en ce qu'il consiste à prévoir un oxyde céramique supraconducteur à base du système Me1-Me2-Cu-O, les constituants métalliques Me1 et Me2 contenant au moins un métal de terre rare ou de l'yttrium et un métal alcalinoterreux respectivement.